# DEMANDE DE BREVET EUROPEEN

(11) **EP 2 996 202 A1**
(43) Date de publication de la demande: **16.03.2016**
(21) Numéro de dépôt: 15184653.2
(22) Date de dépôt: 10.09.2015
(51) Int. Cl.: H01R 13/24, H05K 1/14, F21S 8/10, F21K 99/00, F21V 19/00, F21V 23/06, H01R 12/72, H01R 12/73, H01R 12/58, H05K 3/36, F21Y 105/00

(54) **SUPPORT DE DIODE OLED AVEC LAMELLES ELASTIQUES DE CONNEXION**

(30) Priorité: 15.09.2014 FR 1458674
(71) Demandeur: VALEO VISION, 93012 Bobigny Cedex (FR)
(72) Inventeur: JIN, Hui, 75014 PARIS (FR); BRIAND, Maxime, 72560 CHANGE (FR); ZOJCESKI, Zdravko, 92400 COURBEVOIE (FR); DUBOSC, Christophe, 93250 VILLEMOMBLE (FR); HUE, David, 95430 BUTRY SUR OISE (FR)

(57) **Abrégé**

L'invention a trait à un support de source(s) lumineuse(s) pour module lumineux, notamment pour véhicule automobile, comprenant un substrat (4), au moins une source lumineuse surfacique (8) du type diode à électroluminescence organique supportée par le substrat (4), ladite source ou chacune desdites sources comprend à un ou plusieurs bords au moins deux zones (8¹, 8², 8³) de contact électrique, des pistes électriques (20) déposées sur le substrat (4), et des contacts électriques entre les zones de contact électrique (8¹, 8 ² 8³) de la ou des sources lumineuses (8) et les pistes électriques. Les contacts électriques comprennent des lamelles élastiques (22¹, 22², 22³) en contact sous pression avec la ou les zones de contact (8¹, 8², 8³) de la ou des sources lumineuses surfaciques (8) et avec les pistes électriques (20) sur le substrat (4).

## Description

L'invention a trait au domaine de l'éclairage et/ou de la signalisation lumineuse, notamment pour véhicule automobile. Plus précisément, l'invention a trait au domaine de l'éclairage et de la signalisation lumineuse au moyen de diodes à électroluminescence (LED) et de diodes à électroluminescence organiques (OLED).

Le document de brevet publié DE 20 2013 105 597 U divulgue un support de source lumineuse surfacique du type diode OLED. Le support comprend un substrat étendu supportant la diode OLED et un cache s'étendant essentiellement perpendiculairement au substrat. La diode OLED traverse le cache et comprend des zones de connexion électrique. Ce document divulgue aux paragraphes [0113] et [0139] que le substrat peut comprendre des contacts électriques coopérant avec la diode sur sa partie du côté du cache. Ce document ne précise cependant pas davantage la nature et la configuration de ces contacts électriques.

Le document de brevet publié US 2014/0056020 A1 divulgue un module lumineux pour véhicule automobile, comprenant une série de sources lumineuses surfaciques du type OLED. Ces diodes OLED sont disposées de manière circulaire. Ce document ne semble cependant pas détailler la manière dont les diodes OLED sont supportées. Ces dernières comprennent des connecteurs électriques faisant saillie à un bord. Ce document ne précise cependant pas davantage la manière dont ces connecteurs sont reliés à un dispositif d'alimentation.

Le document de brevet publié FR 2 995 657 A1 divulgue une source de lumière à diodes du type OLED, comprenant un support avec des cavités remplies par les diodes. Le support comprend sur une de ses faces des électrodes ou pistes électriques destinées à contacter électriquement les diodes en vue de leur alimentation électrique. Les diodes comprennent un empilement de couches organiques et un substrat transparent disposé sur l'empilement en question. Le substrat présente une surface de taille supérieure à celle des couches organiques afin de s'étendre au-delà de la cavité correspondante et ainsi à venir contacter les pistes électriques, aux abords de la cavité. Le support est réalisé par injection de matière isolante telle que du plastique thermoplastique ou thermodurcissable. Il peut être plan, avec un ressaut ou encore de forme plus complexe. La connexion électrique entre les pistes électriques et les diodes OLED est intéressante en ce qu'elle est réalisée lors de la mise en place des diodes dans leurs cavités respectives. Ce type de connexion est cependant limité à une configuration très spécifique où les diodes sont insérées dans des cavités.

L'invention a pour objectif de proposer un support de source(s) lumineuse(s) surfacique du type OLED avec un système de connexion efficace.

L'invention a pour objet un support de source(s) lumineuse(s) pour module lumineux, notamment pour véhicule automobile, comprenant : un substrat ; au moins une source lumineuse surfacique du type diode à électroluminescence organique supportée par le substrat, ladite source ou chacune desdites sources comprend au moins deux zones de contact électrique ; des pistes électriques déposées sur le substrat ; des contacts électriques entre les pistes électriques et les zones de contact électrique de la ou des sources lumineuses ; remarquable en ce que les contacts électriques comprennent des lamelles élastiques, en contact sous pression avec les zones de contact de la ou des sources lumineuses surfaciques et avec les pistes électriques.

Les au moins deux zones de contact électrique de la source lumineuse ou de chacune des sources lumineuses sont avantageusement situées à un ou plusieurs bords de ladite source.

Avantageusement, les pistes électriques sont réalisées via un revêtement métallique déposé sur le substrat. Le cas échéant, le revêtement métallique des pistes électriques à l'endroit du contact électrique est choisi de façon à être compatible avec le contact électrique à l'endroit des pistes électriques. Le revêtement métallique à l'endroit du contact électrique et le contact électrique à l'endroit des pistes électriques peuvent par exemple chacun inclure une couche supérieure d'au moins 1µ d'épaisseur comportant un alliage nickel-or, de sorte à garantir la fiabilité du contact électrique. En variante, d'autres alliages tels que l'étain, l'argent ou le nickel-palladium-or peuvent être choisis. Si on le souhaite, la ou chacune des zones de contact électrique peut être lubrifiée de sorte à accroitre la fiabilité du contact électrique.

Selon un mode avantageux de l'invention, la ou chacune des zones de contact électrique de la ou des sources lumineuses surfaciques en contact électrique avec une piste électrique forme un angle avec la zone de ladite piste électrique en contact avec la lamelle élastique, ledit angle étant préférentiellement supérieur à 30°, plus préférentiellement 50°.

Selon un mode avantageux de l'invention, la ou les sources lumineuses surfaciques comprennent chacune deux faces principales opposées, les zones de contact électrique de ladite ou desdites sources lumineuses étant situées sur une desdites faces. La tranche des bords avec les zones de contact sont préférentiellement libre de contact électrique avec lesdites zones de contact.

Selon un mode avantageux de l'invention, chacune des lamelles élastiques comprend au moins deux portions coudées, chacune desdites deux portions coudées étant en contact avec une des zones de contact de la ou des sources lumineuses surfaciques ou avec une des pistes électriques.

Selon un mode avantageux de l'invention, chacune des portions coudées forme un angle intérieur inférieur à 120°, préférentiellement inférieur à 110°, plus préférentiellement inférieur à 100°.

Selon un mode avantageux de l'invention, chacune des lamelles élastiques comprend à au moins une, préférentiellement aux deux, de ses extrémités une portion généralement plane apte à coulisser le long d'une surface de guidage.

Selon un mode avantageux de l'invention, le support comprend une pièce rapportée supportant les lamelles élastiques.

Selon un mode avantageux de l'invention, la pièce rapportée comprend les surfaces de guidage des portions d'extrémité planes des lamelles élastiques.

Selon un mode avantageux de l'invention, la pièce rapportée comprend des rainures formant les surfaces de guidage et recevant les portions d'extrémité planes des lamelles élastiques. Avantageusement, les rainures peuvent être formées par une même encoche de forme crénelée, chaque créneau formant l'une des rainures.

Selon un mode avantageux de l'invention, le substrat comprend une portion étendue, préférentiellement généralement plane, avec deux faces principales opposées et un bord, les pistes électriques étant déposées sur au moins une des deux faces de ladite portion étendue, la ou chacune des sources lumineuses surfaciques s'étendant transversalement à ladite portion avec un bord pourvu des zones de contact adjacent à une desdites faces principales. Le support comprend préférentiellement deux sources lumineuses surfaciques s'étendant de manière essentiellement opposée.

Selon un mode avantageux de l'invention, la ou chacune des sources lumineuses surfaciques forme un angle de moins de 30° avec une direction perpendiculaire au plan moyen de la portion étendue, ledit angle étant préférentiellement inférieur à 25°, plus préférentiellement inférieur à 20°.

Selon un mode avantageux de l'invention, la pièce rapportée comprend au moins une arête supportant les lamelles élastiques.

Selon un mode avantageux de l'invention, les lamelles élastiques chevauchent la ou les arêtes de la pièce rapportée.

Selon un mode avantageux de l'invention, la pièce rapportée comprend deux arêtes supportant les lamelles élastiques, lesdites arêtes s'étendant essentiellement parallèlement l'une à l'autre, la pièce rapportée comprenant une rainure principale entre lesdites arêtes, ladite rainure recevant le bord de la portion étendue du substrat.

Selon un mode avantageux de l'invention, les lamelles élastiques comprennent des premières lamelles chevauchant, chacune, exclusivement une des deux arêtes.

Selon un mode avantageux de l'invention, les premières lamelles ont un profil en forme générale de U et assurent un contact électrique entre des pistes électriques et des zones de contact électrique de la ou des sources lumineuses surfaciques.

Selon un mode avantageux de l'invention, les lamelles comprennent des deuxièmes lamelles, chacune desdites deuxièmes lamelles chevauchant les deux arêtes et s'étendant au travers de la rainure de la pièce rapportée.

Selon un mode avantageux de l'invention, les deuxièmes lamelles ont un profil comprenant deux portions latérales en forme générale de U et chevauchant, chacune, une des deux arêtes et une portion centrale, préférentiellement en forme générale de U opposé aux formes de U des portions latérales.

Selon un mode avantageux de l'invention, les deuxièmes lamelles assurent un contact électrique entre des zones de contact électrique de deux sources lumineuses surfaciques disposées de part et d'autre de la portion généralement plane du substrat.

Selon un mode avantageux de l'invention, le bord de la portion étendue du substrat forme une languette faisant saillie, les pistes électriques sur le substrat s'étendant jusque sur ladite languette, la pièce rapportée comprenant une encoche ou une ouverture apte à recevoir ladite languette de manière à ménager un espace pour son engagement avec un connecteur électrique.

Selon un mode avantageux de l'invention, la pièce rapportée comprend des portions faisant saillie de la portion étendue du substrat et destinée à supporter la ou les sources lumineuses surfaciques.

Selon un mode avantageux de l'invention, le support comprend des sources lumineuses additionnelles du type à électroluminescence et collées directement sur le substrat, lesdites sources étant reliées électriquement aux pistes électriques.

L'invention a également pour objet un module lumineux, notamment pour véhicule automobile, comprenant un support de source(s) lumineuse(s) et au moins un dispositif optique, remarquable en ce que ledit support est conforme à l'invention.

Les mesures de l'invention sont intéressantes en ce qu'elles permettent de réaliser une connexion électrique des sources lumineuses surfaciques de manière propre, simple et efficace. Les lamelles peuvent en effet être mises en place sur la pièce rapportée. Lors de l'assemblage du support, la mise en place de la pièce rapportée va alors assurer, non seulement le maintien mécanique des sources lumineuses surfaciques, mais également leur connexion électrique au substrat.

D'autres caractéristiques et avantages de la présente invention seront mieux compris à l'aide de la description et des dessins parmi lesquels :
- La figure 1 est une vue en perspective d'un module lumineux comprenant un support de sources lumineuses conforme à l'invention ;
- La figure 2 est une vue éclatée du support de sources lumineuses du module de la figure 1, le support comprend un substrat et une pièce rapportée ;
- La figure 3 est une vue de détail du substrat, des sources lumineuses surfaciques du type OLED et des lamelles de contact du module de la figure 1;
- La figure 4 est une vue de détail de la pièce rapportée du support de la figure 2, la pièce rapportée supportant les lamelles de contact ;
- La figure 5 est une vue selon autre perspective de la pièce rapportée de la figure 4 ;
- La figure 6 est une vue des lamelles de contact.

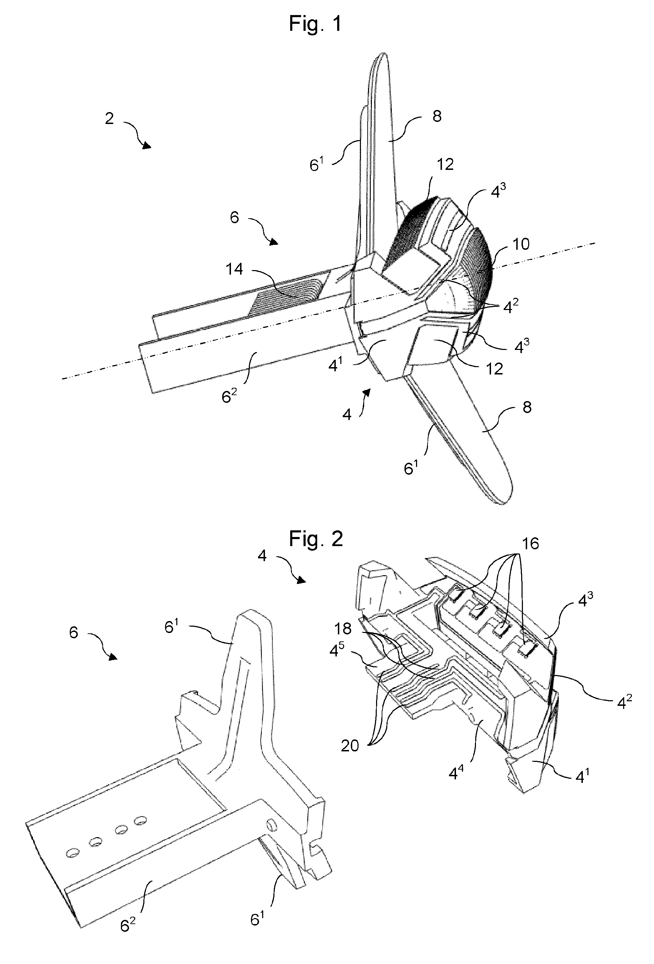

La figure 1 illustre un module de signalisation lumineuse pour véhicule automobile. Le module 2 est configuré pour être logé dans un boîtier disposé à l'arrière du véhicule. Il est configuré pour assurer une fonction de lanterne (ou feux arrière), une fonction de feux stop et une fonction d'indicateur de direction (ou clignotant).

Le module 2 comprend un substrat 4 et une pièce 6 rapportée sur le substrat. La pièce rapportée 6 peut être fixée au substrat au moyen de vis. Le substrat 4 comprend, essentiellement, une partie centrale 4¹, deux parois latérales 4², deux parois frontales 4³ faisant saillie des parois latérales 4². Les deux parois latérales 4² forment une cavité logeant des sources lumineuses (non visibles) ainsi qu'un collimateur 10 en vue de former un faisceau lumineux pour une fonction d'indicateur de direction.

La pièce rapportée 6 comprend deux supports 6¹ et une partie arrière 6². Les supports 6¹ sont disposés de manière à faire saillie de la partie centrale 4¹ du substrat 4 de manière essentiellement opposé l'un à l'autre. Chacun de ces supports 6¹ soutient une diode surfacique du type OLED 8. Une OLED est une diode à électroluminescence comprenant une superposition de plusieurs couches semiconductrices organiques entre deux électrodes dont l'une (au moins) est transparente. En l'occurrence, ces diodes OLED assurent une fonction de lanterne. La partie arrière 6² de la pièce rapport 6 est configurée pour loger un connecteur 14 d'alimentation électrique.

Le substrat 4 du module 2 supporte également une ou plusieurs sources lumineuses (non visibles à la figure 1 mais bien à la figure 2) entre les parois latérales 4² et les diodes OLED 8, cette ou ces sources lumineuses étant recouvertes d'un collimateur 12 en vue d'assurer une fonction de feux stop. Plus précisément, les rayons émis par ces sources lumineuses et déviés par le collimateur 12 pour rencontrer la face avant de la diode OLED 8 correspondante et y être réfléchis vers l'avant du module.

L'axe longitudinal du module représenté aux figures 1 et 2 correspond à son axe optique. Cela signifie que les différents faisceaux lumineux produits par le module 2 sont orientés essentiellement selon cet axe. Tous ces faisceaux sont préférentiellement dirigé vers l'avant du module (correspondant à la droite à la figure 1 et à l'arrière du véhicule).

Les collimateurs 10 et 12 sont des pièces en matière transparente ou translucide, telle que du verre ou du polycarbonate (PC). Ils comprennent des surfaces d'entrée et ou de sorties orientées de manière à dévier les rayons selon une direction principale, en application du principe de réfraction de Snell-Descartes. Les faces d'entrée et de sortie forment en effet chacune un dioptre, à savoir une surface séparant deux milieux transparents homogènes et isotropes, d'indices de réfraction différents. L'indice de réfraction de l'air est en effet de l'ordre de 1 alors que celui du verre et du polycarbonate est situé entre 1.4 et 1.6 environ. Le principe de fonctionnement d'un collimateur est bien connu en soi de l'homme de métier ; il n'est par conséquent pas nécessaire de le détailler davantage.

La figure 2 illustre de manière éclatée le support des sources lumineuses du module 2. Le support comprend le substrat 4 et la pièce rapporté 6. Le substrat 4 comprend, dans sa portion centrale, une portion étendue 4⁴ et une portion 4⁵ faisant saillie de ladite portion étendue 4⁴. Cette portion en saillie 4⁵ est destinée à coopérer par engagement avec le connecteur 6 (figure 1) en vue de l'alimentation électrique des sources lumineuses. Des pistes électriques 18 sont formées à la surface du substrat 4, de manière continue depuis les sources lumineuses jusqu'à la portion de connexion 4⁵. La figure 2 illustre les sources lumineuses 16 du type LED disposées sur la face arrière de la paroi latérale 4² supérieure, étant entendu qu'un agencement similaire est prévu sur la paroi latérale inférieure, cet agencement n'étant pas visible. Des sources lumineuses (non visibles), également du type LED, sont également prévues entre les deux parois latérales 4², au fond de la cavité formée par lesdites parois. Ces sources lumineuses sont également reliées électriquement par les pistes électriques 18.

Les sources lumineuses disposées directement sur le substrat 4, sont ainsi alimentées électriquement par les pistes électriques 18 s'étendant de manière continue depuis lesdites sources jusqu'à la portion de connexion 4⁵.

On peut observer à la figure 2 la présence de pistes électriques 20 dont l'étendue est limitée au bord arrière de la portion étendue 4⁴. Ces pistes servent à alimenter les sources lumineuses surfaciques OLED 8 (figure 1), comme cela va être détaillé en relation avec les figures suivantes.

Le substrat 4, y compris la portion de connexion 4⁵, est en matière plastique réalisée par moulage et supporte les sources lumineuses et les pistes électriques, conformément à la technologie MID (acronyme de « Molded Interconnect Device »).

Le matériau plastique du substrat 4 peut être dopé en particules métalliques aptes à assurer l'accrochage des pistes électriques 18 en matériau métallique sur sa surface extérieure.

Les pistes électriques 18 et 20 peuvent être réalisées par la technologie désignée par l'acronyme LDS signifiant en langue anglaise « Laser Direct Structuring ». Il s'agit de faire parcourir un rayon laser sur la surface correspondante du substrat, suivant la configuration des pistes à réaliser. Le rayon laser a pour effet de former une rugosité apte à favoriser l'accrochage. Cette étape est suivie d'une métallisation par trempage du substrat dans un ou plusieurs bains métalliques successifs.

Alternativement ou de manière complémentaire, les pistes électriques peuvent être réalisées par impression du type jet d'encre dont l'encre comprend des particules métalliques.

Les pistes peuvent également être réalisées par un moulage en deux étapes du substrat, ou encore désigné « Two shot molding » en langue anglaise. Il s'agit d'un processus de moulage par injection en utilisant deux résines différentes où une seule des deux résines est métallisable. Typiquement, la résine métallisable est de l'ABS et la résine non-métallisable est du polycarbonate. Le substrat est ensuite soumis à un processus de dépôt auto-catalytique où du butadiène est utilisé pour chimiquement rendre la surface rugueuse et permettre l'adhérence d'une couche primaire de cuivre.

En raison de la nature thermoplastique du substrat, l'utilisation de procédés de soudure classique pour les contacts électriques n'est pas adaptée. Les LED sont ainsi fixées mécaniquement et électriquement par application d'une colle à base de polymère et chargée en éléments métalliques. Il s'agit ainsi d'un procédé d'application dite « à froid » ne mettant pas à mal le substrat. Après polymérisation de la colle, celle-ci assure la fixation mécanique et électrique de la LED.

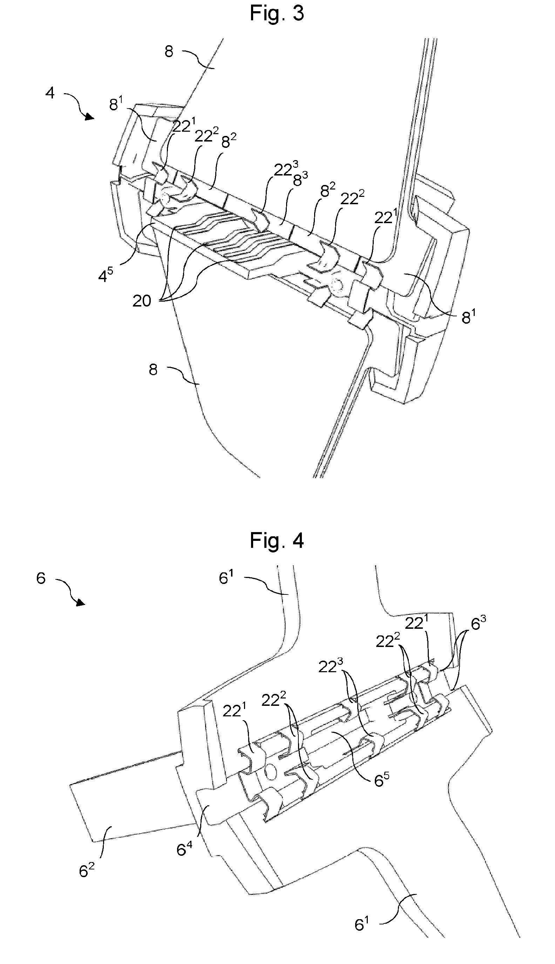

La figure 3 illustre de manière détaillée la connexion électrique entre les diodes surfaciques OLED 8 et les pistes électriques 20 du substrat 4.

On peut observer que chacune des deux diodes surfaciques 8 comprend cinq zones 8¹, 8² et 8³ de contact électrique le long de leurs bords respectifs, ces bords étant adjacents à la portion étendue 4⁴ du substrat 4, de part et d'autre de la dite portion. Les deux zones 8¹ sont situées aux deux extrémités du bord de la diode et sont électriquement reliées, au sein la diode, à la cathode, ou électrode négative, de ladite diode. Les deux zones de contact 8² sont, au sein de la diode, reliées à une première anode, ou électrode positive, alors que la zone de contact 8³ est quant à elle reliée, toujours au sein de la diode, à une deuxième anode. Les première et deuxième anodes recouvrent des zones différentes de l'étendue de la diode alors que la cathode recouvre la totalité des zones des deux anodes. Les diodes présentent ainsi deux zones d'éclairage qui peuvent être alimentées indépendamment l'une de l'autre. Il est à noter que cette configuration est purement exemplative, étant entendu que d'autres configurations sont envisageables.

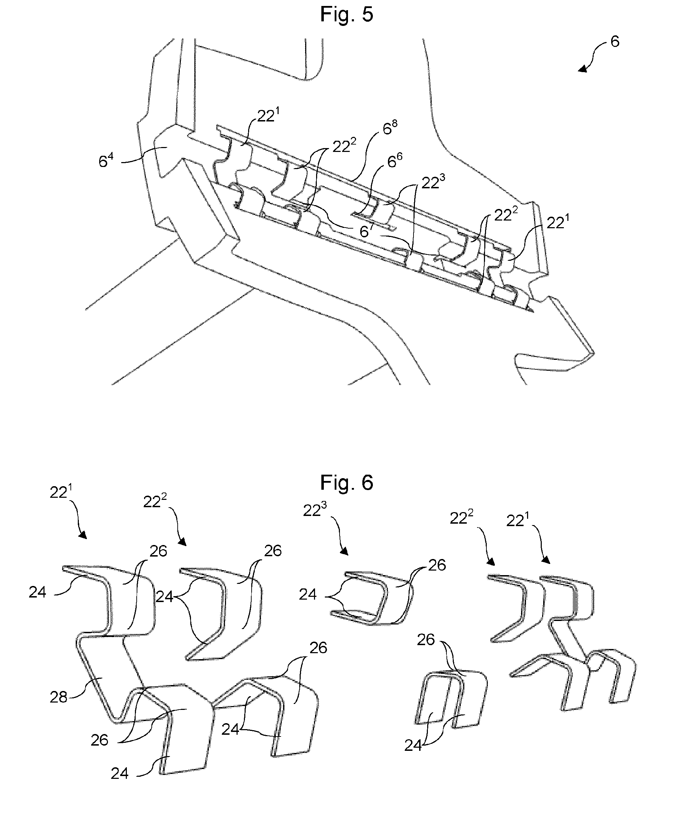

Toujours à la figure 3, on observe également la présence de lamelles de contact élastiques 22¹, 22² et 22³. Ces lamelles sont en réalité supportées par la pièce rapportée 6 comme cela va être détaillé en relation avec les figures 4 et 5. Les lamelles élastiques 22¹, 22² et 22³ sont prévues pour assurer un contact avec pression, c'est-à-dire ne requérant ni soudure ni engagement mécanique à proprement parler. Un premier type de lamelle 22², 22³ est prévu pour assurer un contact électrique entre les zones de contact 8², 8³ des diodes avec les pistes correspondantes sur le bord arrière de la portion étendue 4⁴. Un duxième type de lamelles 22¹ assure une liaison électrique entre les deux diodes surfaciques 8, plus précisément entre leurs zones 8¹ disposées en vis-à-vis, respectivement. Il est à noter que ce qui est visible pour la diode surfacique supérieure l'est également pour la diode inférieure. Il est toutefois à noter qu'à la différence de la face supérieure de la portion étendue 4⁴ du substrat 4, une piste électrique est prévue sur la face inférieure au niveau du bord arrière de ladite portion, à hauteur d'au moins une des lamelles 22¹ afin d'assurer un mise à la masse des zones 8¹ des deux diodes 8.

Les lamelles 22¹, 22² et 22³ peuvent être réalisées à partir d'un feuillard en matériau métallique.

Les figures 4 à 6 illustrent la pièce rapportée et les lamelles élastiques.

Aux figure 4 et 5, on observe que la pièce rapportée 6 comprend sur sa face avant deux arêtes 6³ chevauchées par les lamelles 22¹, 22² et 22³. Les deux arêtes s'étendent essentiellement parallèlement l'une à l'autre de part et d'autre d'une rainure principale 6⁴. Cette dernière est destinée à recevoir le bord arrière de la portion étendue 4⁴ du substrat 4 (figures 2 et 3). La pièce rapportée comprend également un orifice 6⁵ dans le fond et au centre de la rainure 6⁴, cet orifice étant destiné à recevoir la portion de connexion 20 du substrat (figures 2 et 3).

Plus particulièrement en référence à la figure 5, on peut observer que la pièce rapportée 6 comprend des rainures de guidage 6⁶, 6⁷ et 6⁸, ces rainures recevant de manière coulissante les extrémités des lamelles 22¹, 22² et 22³.

En référence à la figure 6, on observe que chacune des lamelles 22¹, 22² et 22³ comprend à ses deux extrémités des portions 24 généralement planes. On constate également que chacune de ces lamelles forme au moins deux portions coudées 26. Plus précisément, les lamelles 22² et 22³ présentent, chacune, un profil en forme générale de U de manière à former les deux portions coudées 26 et les deux portions planes 24. Les lamelles 22² présentent toutefois un profil s'évasant alors que les lamelles 22³ présentent un profil dont les bords, ou encore les portions planes 24, sont généralement parallèles. Les lamelles 22¹ sont quelque peu différentes en ce que leur profil comprend deux portions latérales en U et une portion centrale 28 reliant les deux portions latérales. La portion centrale 28 s'étendant depuis les portions planes 26 forme également un U qui est toutefois généralement opposé aux formes en U des portions latérales. La portion centrale 28 est destinée à être logée dans le fond de la rainure 6⁴ de la pièce rapportée, comme cela est visible aux figures 4 et 5.

Les portions coudées 26 des lamelles sont destinées à contacter les zones de contact électrique 8¹, 8² et 8³ des diodes surfaciques 8 ainsi que les pistes électriques 20 sur le substrat 4 (figures 2 et 3).

## Revendications

1. Support de source(s) lumineuse(s) pour module lumineux, notamment pour véhicule automobile, comprenant :
- un substrat (4) ;
- au moins une source lumineuse surfacique (8) du type diode à électroluminescence organique supportée par le substrat (4), ladite source ou chacune desdites sources au moins deux zones de contact électrique (8¹, 8², 8³) ;
- des pistes électriques (18, 20) déposées sur le substrat (4) ;
- des contacts électriques entre les pistes électriques (20) et les zones de contact électrique (8², 8³) de la ou des sources lumineuses (8) ;
**caractérisé en ce que**
les contacts électriques comprennent des lamelles élastiques (22¹, 22², 22³), en contact sous pression avec les zones de contact (8¹, 8², 8³) de la ou des sources lumineuses surfaciques et avec les pistes électriques (20).

2. Support selon la revendication 1, **caractérisé en ce que** la ou chacune des zones de contact électrique (8², 8³) de la ou des sources lumineuses surfaciques (8) en contact électrique avec une piste électrique (20) forme un angle avec la zone de ladite piste électrique (20) en contact avec la lamelle élastique, ledit angle étant préférentiellement supérieur à 30°, plus préférentiellement 50°.

3. Support selon l'une des revendications 1 et 2, **caractérisé en ce que** chacune des lamelles élastiques (22¹, 22², 22³) comprend au moins deux portions coudées (26), chacune desdites deux portions coudées étant en contact avec une des zones de contact électrique (8¹, 8², 8³) de la ou des sources lumineuses surfaciques (8) ou avec une des pistes électriques (20).

4. Support selon l'une des revendications 1 à 3, **caractérisé en ce que** chacune des lamelles élastiques (22¹, 22², 22³) comprend à au moins une, préférentiellement aux deux, de ses extrémités une portion généralement plane (24) apte à coulisser le long d'une surface de guidage.

5. Support selon l'une des revendications 1 à 4, **caractérisé en ce qu'**il comprend une pièce rapportée (6) supportant les lamelles élastiques (22¹, 22², 22³).

6. Support selon les revendications 4 et 5, **caractérisé en ce que** la pièce rapportée (6) comprend les surfaces de guidage des portions d'extrémité planes (24) des lamelles élastiques (22¹, 22², 22³).

7. Support selon la revendication 6, **caractérisé en ce que** la pièce rapportée (6) comprend des rainures de guidage (6⁶, 6⁷, 6⁸) formant les surfaces de guidage et recevant les portions d'extrémité planes (24) des lamelles élastiques (22¹, 22², 22³).

8. Support selon l'une des revendications 5 à 7, **caractérisé en ce que** la pièce rapportée (6) comprend au moins une arête (6³) supportant les lamelles élastiques (22¹, 22², 22³).

9. Support selon la revendication 8, **caractérisé en ce que** la pièce rapportée (6) comprend deux arêtes (6³) supportant les lamelles élastiques (22¹, 22², 22³), lesdites arêtes s'étendant essentiellement parallèlement l'une à l'autre, la pièce rapportée comprenant une rainure principale (6⁴) entre lesdites arêtes, ladite rainure recevant le bord de la portion étendue (4⁴) du substrat (4).

10. Support selon la revendication 9, **caractérisé en ce que** les lamelles élastiques (22¹, 22², 22³) comprennent des premières lamelles (22², 22³) chevauchant, chacune, exclusivement une des deux arêtes.

11. Support selon la revendication 10, **caractérisé en ce que** les premières lamelles (22², 22³) ont un profil en forme générale de U et assurent un contact électrique entre des pistes électriques (20) et des zones de contact électrique (8², 8³) de la ou des sources lumineuses surfaciques (8).

12. Support selon l'une des revendications 10 et 11, **caractérisé en ce que** les lamelles (22¹, 22², 22³) comprennent des deuxièmes lamelles (22¹), chacune desdites deuxièmes lamelles chevauchant les deux arêtes (6³) et s'étendant au travers de la rainure principale (6⁴) de la pièce rapportée (6).

13. Support selon la revendication 12, **caractérisé en ce que** les deuxièmes lamelles (22¹) ont un profil comprenant deux portions latérales (24, 26) en forme générale de U et chevauchant, chacune, une des deux arêtes et une portion centrale (28), préférentiellement en forme générale de U opposé aux formes de U des portions latérales.

14. Support selon l'une des revendications 12 et 13, **caractérisé en ce que** les deuxièmes lamelles (22¹) assurent un contact électrique entre des zones de contact électrique (8¹) de deux sources lumineuses surfaciques (8) disposées de part et d'autre de la portion étendue (4⁴) du substrat (4).

15. Support selon l'une des revendications 5 à 14, **caractérisé en ce que** le bord de la portion étendue (4⁴) du substrat (4) forme une languette (4⁵) faisant saillie, les pistes électriques (18, 20) sur le substrat (4) s'étendant jusque sur ladite languette (4⁵), la pièce rapportée (6) comprenant une encoche ou une ouverture (6⁵) apte à recevoir ladite languette (4⁵) de manière à ménager un espace pour son engagement avec un connecteur électrique (14).

16. Module lumineux, notamment pour véhicule automobile, comprenant un support de source(s) lumineuse(s) et au moins un dispositif optique, **caractérisé en ce que** ledit support est conforme à l'une des revendications 1 à 15.
